Europäisches Patentamt

European Patent Office

Office européen des brevets

(11) Veröffentlichungsnummer: **0 200 881**
**A2**

# EUROPÄISCHE PATENTANMELDUNG

(21) Anmeldenummer: 86103131.8

(22) Anmeldetag: 08.03.86

(51) Int. Cl.⁴: **H03G 7/00** , H03G 11/00

(30) Priorität: 03.04.85 DE 3512090

(43) Veröffentlichungstag der Anmeldung:
. **17.12.86 Patentblatt 86/46**

(84) Benannte Vertragsstaaten:
**CH DE FR GB IT LI NL**

(71) Anmelder: **ELTRO GmbH Gesellschaft für Strahlungstechnik**
**Kurpfalzring 106 Postfach 10 21 20**
**D-6900 Heidelberg 1(DE)**

(72) Erfinder: **Merdes, Friedrich**
**Sandhäuser Strasse 2**
**D-6836 Oftersheim(DE)**
Erfinder: **Weigel, Wolfgang**
**Dachsweg 2**
**D-6901 Dossenheim(DE)**

(74) Vertreter: **Muschka, Wilhelm, Dipl.-Ing.**
**Eltro GmbH Gesellschaft für Strahlungstechnik Kurpfalzring 106 Postfach 10 21 20**
**D-6900 Heidelberg 1(DE)**

(54) **Verfahren und Schaltungsanordnung zum Aufbereiten von gleichzeitig zur Verarbeitung anstehenden sehr unterschiedlich grossen Amplituden.**

(57) Verfahren und Schaltungsanordnung zum Aufbereiten von gleichzeitig zur Verarbeitung anstehenden sehr unterschiedlich großen Signalamplituden unter Verwendung eines Signaldetektors, der die elektrischen Signale über einen AC-gekoppelten Schaltkreis einer Signalverarbeitung zuführt. Die Verstärker dieses Schaltkreises sollen Signale sehr unterschiedlicher Größenordnung verstärken, keine Amplitudenbegrenzung der schwachen Signale bewirken und keine Fehler durch die AC-Kopplung entstehen lassen. Hierzu vergrößert man den Dynamikbereich des Vorverstärkers, begrenzt die positive Amplitude am Eingang des Nachverstärkers, vermeidet die Beeinflussung der negativen Amplitude und verwendet einen zweistufigen Nachverstärker spezieller Bauart

Fig. 1

Verfahren und Schaltungsanordnung zum Aufbereiten von gleichzeitig zur Verarbeitung anstehenden sehr unterschiedlich großen Amplituden

Die Erfindung bezieht sich auf Verfahren zum elektronischen Aufbereiten von gleichzeitig zur Verarbeitung anstehenden Signalamplituden extremer Größen nach dem Oberbegriff des Anspruchs 1 sowie auf eine Schaltungsanordnung zur Durchführung dieses Verfahrens.

Der Erfindung liegt die Aufgabe zugrunde, das gattungsgemäße Verfahren so zu verbessern, daß die hierbei zur Anwendung gelangenden Verstärker Signale sehr unterschiedlicher Größenordnung verstärken, keine Amplitudenbegrenzungen zu - schwache oder abgeschnittene Signale bewirken und auch keine Fehler durch hierbei zur Anwendung gelangende AC-Kopplungen (= alternating current = wechselspannungsgemäß) entstehen. Diese Aufgabe wird erfindungsgemäß durch die im Kennzeichen des Anspruchs 1 angegebenen Merkmale gelöst. Dies bringt den Vorteil mit sich, daß sich Amplituden von Objekten mit wesentlich höheren Temperaturunterschieden übertragen lassen.

Eine Weiterbildung der Erfindung gemäß Anspruch 4 macht es möglich,daß der Dynamikbereich von Wärmebildgeräten erhöht wird, ohne das Eingangsrauschen und der Stromverbrauch ansteigen. Darüberhinaus sind die Signale in einer Polarität begrenzt. Die entsprechenden Platinen lassen sich hierbei so auslegen, daß sie sich auch für die Nachrüstung bzw. Verbesserung bereits vorhandener Geräte verwenden lassen.

Auch die restlichen Unteransprüche enthalten Weiterbildungen der Erfindung.

Im folgenden wird an Hand einer Zeichnung ein Ausführungsbeispiel der Erfindung näher erläutert, wobei die in den ei nzelnen Figuren einander entsprechenden Teile dieselben Bezugszahlen aufweisen. Es zeigt

Fig. 1 das stark vereinfachte Blockschaltbild des erfindungsgemäßen Verfahrens,

Fig. 2 den gleichzeitigen Empfang von großen und kleinen Signal-Amplituden durch ein Wärmebildgerät -dargestellt am Ausgang des Detektors,

Fig. 3 die Begrenzung der Signalamplituden gemäß Fig. 2 im positiven und negativen Bereich am Ausgang des bisherigen Nachverstärkers,

Fig. 4 das Ausgangssignal des Detektors gemäß Fig. 2,

Fig. 5 den aus der fehlenden Begrenzung gemäß Fig. 4 resultierenden Amplitudenabfall $\Delta A$ am Ausgangssignal des Nachverstärkers,

Fig. 6 das unbegrenzte Ausgangssignal des Vorverstärkers,

Fig. 7 das positiv begrenzte Ausgangssignal der 1. Stufe des Nachverstärkers, mit unveränderter negativer Amplitude,

Fig. 8 eine Vergrößerungsmöglichkeit des Dynamikbereichs des aus Fig. 1 ersichtlichen Vorverstärkers,

Fig. 9 die elektronische Schaltung der ersten Stufe des in Fig. 1 als Blockschaltbild angedeuteten Nachverstärkers,

Fig. 10 den Zusammenhang des Verstärkungssignals in Volt und der Verstärkung in dB in der ersten Stufe des Nachverstärkers,

Fig. 11 die elektronische Schaltung der zweiten Stufe des in Fig. 1 als Blockschaltbild angedeuteten Nachverstärkers,

Fig. 12 das Blockschaltbild der zweiten Stufe des Nachverstärkers gemäß Fig. 11 und

Fig. 13 die Begrenzungskennlinie des das verstärkte Eingangssignal begrenzenden NF-Verstärkers.

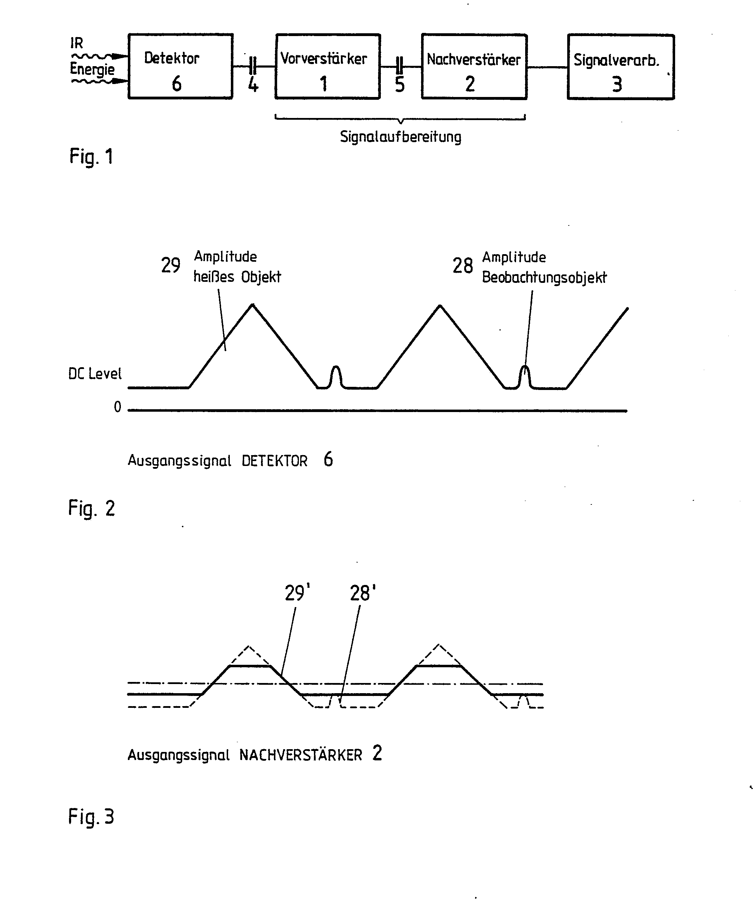

Die erfindungsgemäße Signalaufbereitung kann grundsätzlich überall Verwendung finden, wo einerseits eine AC-Kopplung eingesetzt wird und wo andererseits verschieden große Signale auftreten, deren Trennung man beabsichtigt. Nachfolgend soll diese Signalaufbereitung an Hand eines in Fig. 1 lediglich durch seinen IR-Detektor 6 angedeutetes Wärmebildgerät beschrieben werden, bei dem IR-Energie über eine IR-Optik, eine Abtasteinheit und ein Detektorobjektiv auf den IR-Detektor 6 trifft, der die Energie auf opto-elektronischem Weg in elektrische Signale umwandelt, um sie sodann über den Kondensator 4 dem Vorverstärker 1, dem Kondensator 5 und dem Nachverstärker 2 der Signalverarbeitung 3 zuzuführen. Die Kondensatoren sind hierbei für entsprechende Bandbreiten optimiert, um auf diese Weise eine Gleichspannungsunterdrückung zu erreichen.

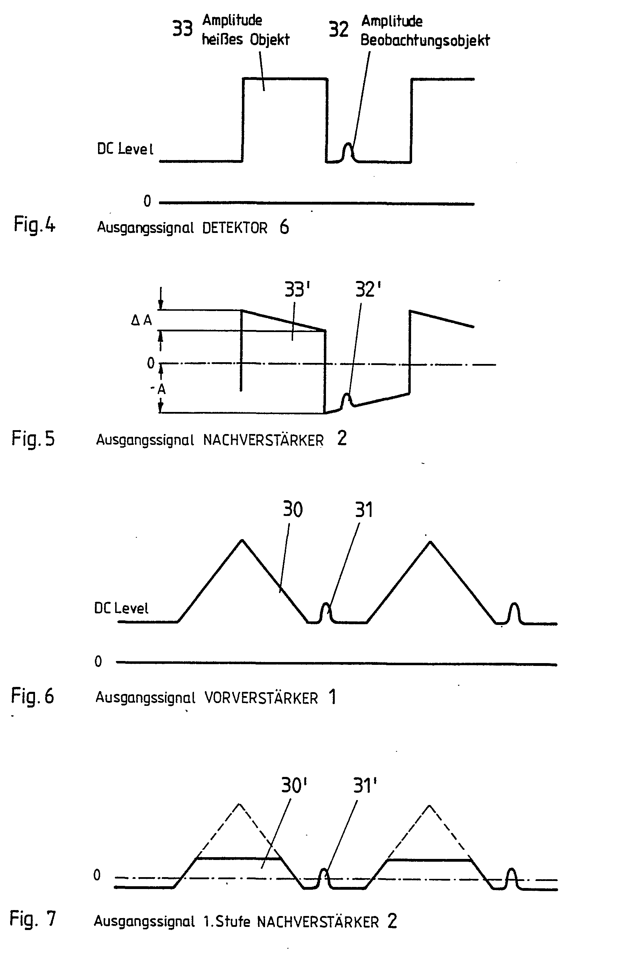

Die Signalaufbereitung 1, 2, 4 und 5 eines Wärmebildgerätes ist grundsätzlich so ausgelegt, daß sie sehr kleine Temperaturdifferenzen bzw. deren Amplituden verarbeiten kann. Es kommt aber in der Praxis vor, daß am Ausgang des Detektors 6 gemäß Fig. 2 gleichzeitig kleine und große Temperaturdifferenzen auftreten. Eine entsprechend kleine Amplitude 28 rührt von einem Beobachtungsobjekt her und hat z.B. eine Temperaturdifferenz von $\Delta t = 1°$ C, während eine entsprechend größere Amplitude 29 von einem heißen Objekt herrührt und eine Temperaturdifferenz von z.B. $\Delta t = 1000°$ bis $2000°$ besitzt. Hierbei ergeben sich folgende den Fig. 3 und 5 entnehmbare unerwünschte Effekte, die einmal die Signalbegrenzung betreffen und zum anderen aus der Verstärkerkopplung resultieren.

Die Signalbegrenzung bewirkt, daß die Verstärker 1 und 2 kleine Signale von z.B. $\Delta T_{max} = 50°$ C verstärken können und heißte Objekte mit einer höheren Temperatur dadurch gemäß Fig. 3 sowohl auf der negativen als auch auf der positiven Seite der Amplituden 28' und 29' begrenzt werden. Die Folge ist, daß Signale von Beobachtungsobjekten mit einer kleinen Temperaturdifferenz von z.B. nur $\Delta T = 1°C$ regelrecht abgeschnitten und somit gar nicht mehr übertragen werden.

Aus der AC-Kopplung der Verstärker kann sich gemäß Fig. 4 ergeben, daß die Verstärker von einem heißen Objekt von z.B. $\Delta T = 30°$ C hinsichtlich ihrer Amplituden 32 und 33 nicht begrenzt werden. Es entsteht dann ein an den entsprechenden Amplituden 32' und 33' erkennbarer Amplitudenabfall $\Delta A$ und gleichzeitig eine negative Amplitude -A. Dies bewirkt eine scheinbare Temperaturabsenkung des Beobachtungsobjektes bei konstant gehaltener Helligkeitseinstellung; das Beobachtungsobjekt wird nur noch sehr schwach oder gar nicht mehr dargestellt.

Dies alles bedeutet, daß bei der Beobachtung einer Szene von Beobachtungsobjekten kleiner Temperaturdifferenz mittels eines Wärmebildgerätes sowohl Verstärkung als auch Helligkeit auf diese Objekte optimiert werden. Tritt aber ein Objekt oder treten mehrere Objekte mit großer Temperaturdifferenz in die Szene, so wird bzw. werden in Abhängigkeit des $\Delta T$ der heißen Objekte Beobachtungsobjekte mit kleinem $\Delta T$ nicht mehr dargestellt, das heißt der Beobachter verliert das Ziel während des Zielvorgangs.

Um zu vermeiden, daß die AC-gekoppelten Verstärker 1 und 2 unabhängig von der Größe der in Fig. 6 dargestellten Amplitude von der Temperaturdifferenz verschiedener Objekte in die negative Begrenzung kommen, muß einmal der Dynamikbereich des Vorverstärkers 1 vergrößert und gemäß Fig. 7 die positive Amplitude 30' bzw. 31' am Eingang des Nachverstärkers 2 begrenzt sowie die negative Amplitude möglichst nicht beeinflußt werden.

## Vorverstärker

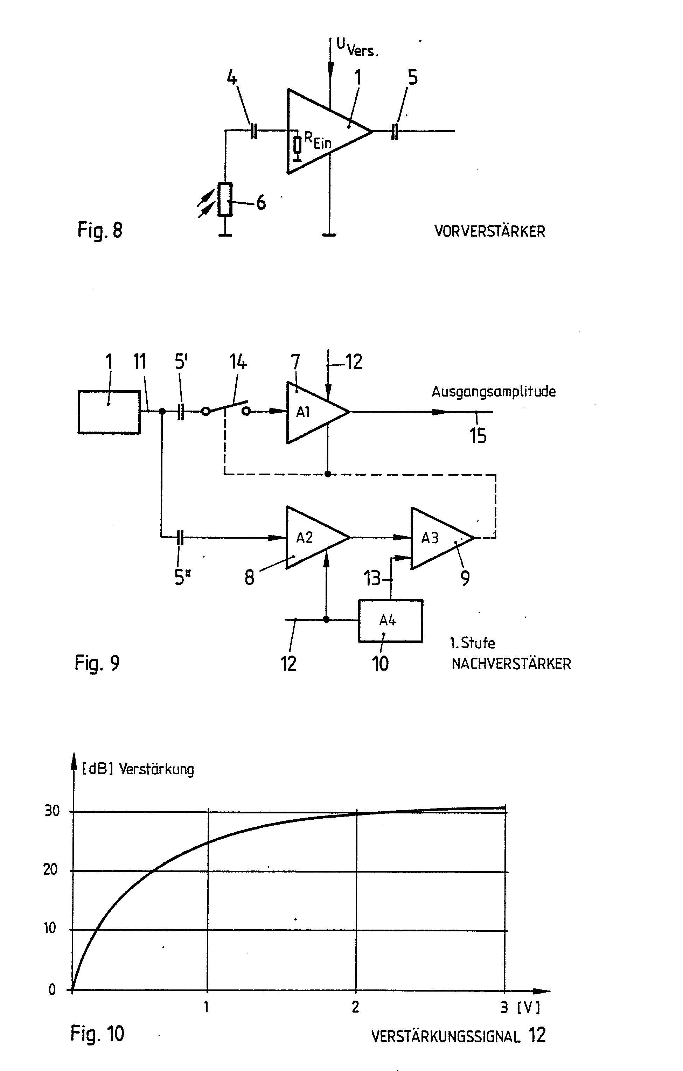

Die Vergrößerung des Dynamikbereichs im Vorverstärker 1 von z.B. 60 dB auf 75 dB wird gemäß Fig. 8 dadurch realisiert, daß man die Versorgungsspannung $U_{Vers}$ von 3,5 V auf 4,0 V erhöht. Dies bedeutet, daß jetzt Amplituden von Objekten bis ca. $2000°$ C übertragen werden können. Um den Amplitudenabfall $\Delta A$ lediglich in einem vertretbaren Ausmaß und ohne eine Erhöhung des Verstärker-Eingangsrauschens

$$\left(von \ \underline{\frac{1,5 \ nV}{Hz}} \ \right)$$

zur verringern, muß sodann der Eingangswiderstand $R_{Ein}$ erhöht werden.

## Erste Stufe des Nachverstärkers

Die vom Vorverstärker 1 gelieferte unbegrenzte Amplitude gelangt gemäß Fig. 9 über je einen Kondensator in zwei Verstärkerzweige. Der erste besteht lediglich aus dem Verstärker 7 und dem ihm vorgeschalteten Schalter 14. An seinem Ausgang steht die Ausgangsamplitude 15. Der andere Verstärkerzweig besteht aus den in Reihe geschalteten Verstärkern 8 und 9, wobei den Verstärkern 7 und 8 jeweils über einen weiteren Eingang das Verstärkungssignal 12 zugeführt wird. Aus letzterem wird sodann über die Stufe 10 das auf einen Eingang des Verstärkers 9 gelangende Referenzsignal 13 abgeleitet. Der Verstärker 9 vergleicht nun die durch den Verstärker 8 verstärkte Eingangsamplitude 11. Wenn dieselbe größer ausfällt als das Referenzsignal 13, öffnet der Verstärker 9 den Schalter 14, wie dies durch die unterbrochene Linienführung vom Ausgang dieses Verstärkers zum Schalter angedeutet ist, und hält die Ausgangsamplitude 15 des Verstärkers 7 auf dem letzten noch vor seiner Öffnung vorhandenen Wert. Unterschreitet dagegen die Eingangsamplitude das Referenzsignal, schließt der Verstärker 9 den Schalter 14 und schaltet dadurch den Verstärker 7 von dem statischen in den dynamischen Bereich zurück.

In dem gewählten Ausführungsbeispiel eines Wärmebildgerätes wird das Verstärkungssignal 12 vom Beobachter über die Kontrastregelung eingestellt. Bei einem kleinen $\Delta T$ des Beobachtungsobjektes erhält man hierbei ein großes Verstärkungssignal und umgekehrt.

Den Zusammenhang des Verstärkungssignals 12 und der durch die Verstärker 7 und 8 erreichten Verstärkung zeigt die angenähert logarithmische Verstärkungskennlinie von Fig. 10.

Zweite Stufe des Nachverstärkers

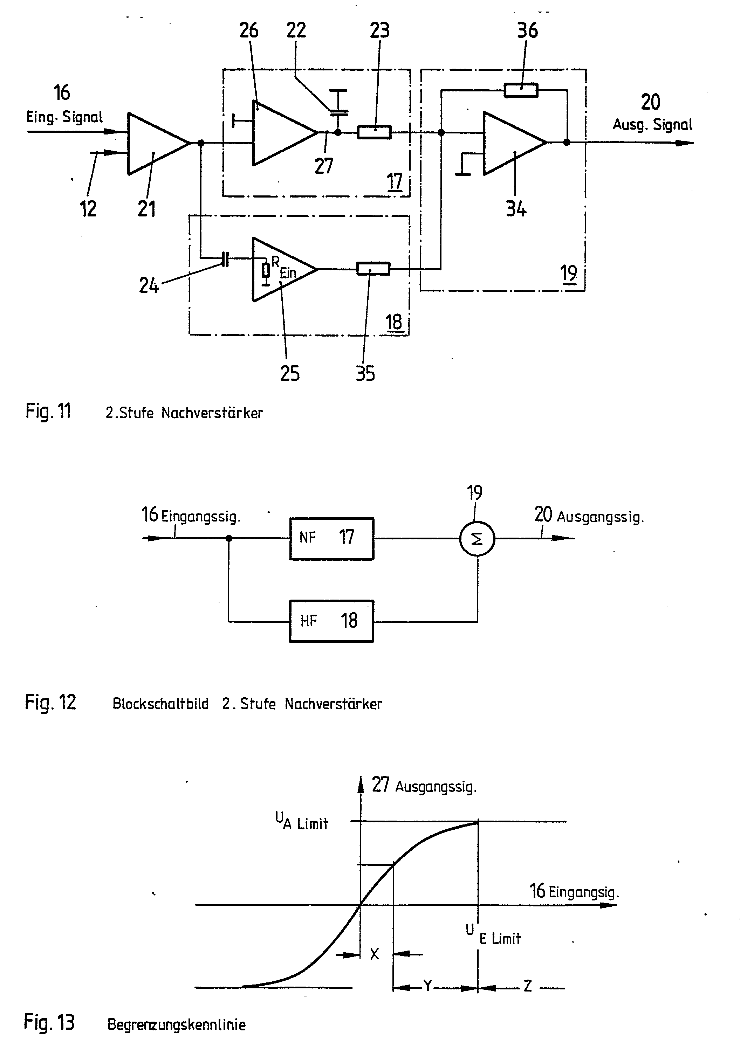

Das von der vorbeschriebenen 1. Stufe des Nachverstärkers 2 (Fig. 1) gelieferte Eingangssignal 16 für die in Fig. 11 dargestellte und als automatischer Niederfrequenz-Signal-Begrenzer arbeitende 2. Stufe besteht aus nieder-und hochfrequenten Signalen. NF-Signale sind hierbei alle Signale <3,4 kHz und HF-Signale alle Signale > 3,4 kHz. Das Eingangssignal 16 wird in dem Eingangsverstärker 21 verstärkt und gelangt sodann in den dieses Signal entsprechend der in Fig. 13 dargestellten Kennlinie begrenzenden Verstärker 26 des NF-Kanals 17.

Der NF-Kanal 17 setzt sich zusammen aus dem schon erwähnten NF-Verstärker 26, dem mit ihm ausgangseitig in Reihe geschalteten NF-Widerstand 23 und dem NF-Kondensator 22, der mit seinem einen Ende an Masse und mit seinem anderen zwischen Verstärker und Widerstand gekoppelt ist. Die Bandbegrenzung dieses Kanal für den oberen -3 dB Punkt wird durch Kondensator 22 und Widerstand 23 bestimmt.

Der HF-Kanal 18 setzt sich zusammen aus einer Serienschaltung des HF-Kondensators 24, des HF-Verstärkers 25 und des HF-Widerstands 35. Dieser Serienzweig ist mit seinem einen Ende zwischen den Ausgang des Verstärkers 21 und den Eingang des NF-Verstärkers 26 und mit seinem anderen Ende zwischen den NF-Widerstand 23 und den Eingang des Endverstärkers 34 gekoppelt. Die Bandbegrenzung für den unteren 3 dB Punkt wird durch den HF-Kondensator 24 und den HF-Verstärker 25 bestimmt. Dieser Endverstärker bildet mit dem ihn überbrückenden Widerstand 36 und den Widerständen 23 und 35 die Summenstufe 19. Summenstufe, NF-Kanal und HF-Kanal sind zur besseren Kenntlichmachung dieser Baueinheiten mit einer strichpunktierten Linie umrandet.

Ist laut Fig. 13 das Eingangssignal 16 größer als $U_{E\ Limit}$, so werden Frequenzen unterhalb 3,4 kHz in ihrer Amplitude begrenzt in die Summenstufe 19 der Fig. 12 geleitet, während Frequenzen über 3,4 kHz mittels des HF-Kanals 18 in die Summenstufe gelangen. Ist das Eingangssignal kleiner, so gelangen die NF-Anteile über den NF-Kanal 17 und die HF-Anteile über den HF-Kanal 18 in die Summenstufe. Dies bedeutet, daß bei einem Eingangssignal kleiner als $U_{E\ Limit}$ die Verstärkungskennlinie des NF-Verstärkers 26 für den NF-und den HF-Kanal im Bereich x linear und im Bereich y für den NF-Kanal logarithmisch verläuft. Ist das Eingangssignal dagegen größer als $U_{E\ Limit}$, so ist der NF-Verstärker im Bereich z in seiner Ausgangsamplitude $U_{A\ Limit}$ konstant.

Die Summenstufe 19 in Fig. 12 addiert die NF-und HF-Signale aus dem NF-Kanal 17 bzw. HF-Kanal 18 zum Ausgangssignal 20, das nun zur Signalverarbeitung 3 (Fig. 1) zur Verfügung steht. Es läßt sich z.B. als LED-Treiber zum Ansteuern einer LED-Reihe verwenden. Darüberhinaus ist auch die Steuerung eines Trackers, einer Normwandlung oder einer Digitalisierung und Speicherung denkbar.

**Ansprüche**

1. Verfahren zum elektronischen Aufbereiten von gleichzeitig zur Verarbeitung anstehenden sehr unterschiedlich großen Signalamplituden, unter Verwendung eines die Signale empfangenden und in elektrische Signale umwandelnden Detektors, wobei die elektrischen Signale über einen die Bandbreite optimierenden ersten Kondensator, einen Vorverstärker, einen die Bandbreiten optimierenden zweiten Kondensator und einen Nachverstärker einer Signalverarbeitung zugeführt werden, **dadurch gekennzeichnet, daß**

a) der Dynamikbereich des Vorverstärkers (1) vergrößert,

b) die positive Amplitude (11) am Eingang des Nachverstärkers (2) begrenzt,

c) die negative Amplitude nicht beeinflußt und

d) ein zweistufiger Nachverstärker verwendet wird.

2.Verfahren nach Anspruch 1, **dadurch gekennzeichnet,** daß für eine Vergrößerung des Dynamikbereichs im Vorverstärker (1) die Versorgungsspannung $U_{Vers}$ erhöht wird (Fig. 8).

3. Verfahren nach Anspruch 1, **dadurch gekennzeichnet**, daß für einen geringeren Amplitudenabfall ΔA am Ausgangssignal des Nachverstärkers (2) der Eingangswiderstand ($R_{Ein}$) des Vorverstärkers (1) bei unverändertem Eingangsrauschen erhöht wird (Fig. 8).

4. Verfahren nach einem der Ansprüche 1 bis 3, das **gekennzeichnet** ist durch seine Verwendung in einem Wärmebildgerät, welches über eine IR-Optik, eine Abtasteinheit und ein Detektorobjektiv IR-Energie auf einem IR-Detektor (6) empfängt, dieselbe auf optoelektronischem Weg in elektrische Signale umwandelt und über wechselspannungsgekoppelte Verstärker (1, 2) der Signalverarbeitung (3) zuführt (Fig. 1).

5. Schaltungsanordnung zur Durchführung des Verfahrens nach einem der Ansprüche 1 bis 4, **dadurch gekennzeichnet**, daß die vom Vorverstärker (1) gelieferte unbegrenzte Amplitude (11) gleichzeitig über einen Kondensator (5') in den ersten Verstärker (7) und über einen weiteren Kondensator (5") in den zweistufigen zweiten Verstärker (8) gelangt, und daß ein Komparator (9) die durch den zweiten Verstärker verstärkte Amplitude mit einem vom Verstärkungssignal (12) abgeleiteten Referenzsignal (13) vergleicht (Fig. 9).

6. Schaltungsanordnung nach Anspruch 5, **dadurch gekennzeichnet**, daß als Folge des Vergleichs der Komparator (9) in der ersten Stufe einen zwischen dem Kondensator (5') und dem ersten Verstärker (7) vorgesehenen Schalter (14) öffnet sowie die Ausgangsamplitude (15) des Verstärkers auf dem letzten Wert -als die Schaltung noch geschlossen war -hält, sofern die Eingangsamplitude (11) größer ist als das Referenzsignal (13), während beim Unterschreiten des Referenzsignals durch die Eingangsamplitude der Komparator den Schalter schließt und den ersten Verstärker vom statischen in den dynamischen Bereich schaltet (Fig. 9).

7. Schaltungsanordnung nach Anspruch 5 und 6, **dadurch gekennzeichnet**, daß das von der ersten Stufe des Nachverstärkers (2) gelieferte Eingangssignal (16) über einen NF-Kanal (17) und einen HF-Kanal (18), die zueinander parallel geschaltet sind, einer Summenstufe (19) zugeführt wird (Fig. 11).

8. Schaltungsanordnung nach Anspruch 7, **dadurch gekennzeichnet**, daß der NF-Kanal (17) aus einem NF-Verstärker (26), einem zwischen ihm und der Summenstufe (19) geschalteten NF-Widerstand (23) sowie einem NF-Kondensator (22) besteht, der mit seinem einen Ende an Masse liegt und mit seinem anderen zwischen den Ausgang des NF-Verstärkers und den NF-Widerstand gekoppelt ist (Fig. 11).

9. Schaltungsanordnung nach Anspruch 7, **dadurch gekennzeichnet**, daß sich der HF-Kanal (18) aus einem Serienzweig eines HF-Kondensators (24), eines HF-Verstärkers (25) und eines HF-Widerstands (35) zusammensetzt, dessen eines Ende zwischen den Ausgang des Verstärkers (21) und den Eingang des NF-Verstärkers (26) und dessen anderes Ende zwischen den NF-Widerstand (23) und die Summenstufe (19) gekoppelt ist (Fig. 11).

10. Schaltungsanordnung nach einem der Ansprüche 7 bis 9, **dadurch gekennzeichnet**, daß die Summenstufe (19) aus einem von einem Widerstand (36) überbrückten Endverstärker (34) sowie den Widerständen (23 u. 35) besteht und ein Ausgangssignal (20) liefert (Fig. 11).

Fig. 1

Ausgangssignal DETEKTOR 6

Fig. 2

Ausgangssignal NACHVERSTÄRKER 2

Fig. 3

33 Amplitude
heißes Objekt   32 Amplitude
Beobachtungsobjekt

DC Level

0

**Fig. 4**   Ausgangssignal DETEKTOR 6

33'   32'

Δ A

0

- A

**Fig. 5**   Ausgangssignal NACHVERSTÄRKER 2

30   31

DC Level

0

**Fig. 6**   Ausgangssignal VORVERSTÄRKER 1

30'   31'

0

**Fig. 7**   Ausgangssignal 1.Stufe NACHVERSTÄRKER 2

Fig. 8         VORVERSTÄRKER

Fig. 9

1.Stufe
NACHVERSTÄRKER

Fig. 10        VERSTÄRKUNGSSIGNAL 12

Fig. 11    2.Stufe Nachverstärker

Fig. 12    Blockschaltbild  2. Stufe  Nachverstärker

Fig. 13    Begrenzungskennlinie